# EUROPÄISCHE PATENTSCHRIFT

(11) **EP 1 995 779 B1**
(45) Veröffentlichungstag und Bekanntmachung des Hinweises auf die Patenterteilung: **14.12.2011**
(21) Anmeldenummer: 08008716.6
(22) Anmeldetag: 09.05.2008
(51) Int. Cl.: H01L 23/053, H01L 23/10, H05K 7/10, H01L 25/07

(54) **Leistungshalbleitermodul**
Power semiconductor module
Module semi-conducteur de puissance

(30) Priorität: 24.05.2007 DE 102007024159
(43) Veröffentlichungstag der Anmeldung: 26.11.2008
(73) Patentinhaber: SEMIKRON Elektronik GmbH & Co. KG, 90431 Nürnberg (DE)
(72) Erfinder: Popp, Rainer, 91580 Petersaurach (DE); Lederer, Marco, 90453 Nürnberg (DE)

(56) Entgegenhaltungen:
- EP-A2- 1 921 909
- DE-A1- 3 604 882
- DE-A1- 19 518 753
- DE-A1- 19 630 173
- US-A1- 2002 153 532

## Beschreibung

Die Erfindung betrifft ein Leistungshalbleitermodul mit einem Substrat und einem becherförmigen Gehäuse, wobei der Becherrand des Gehäuses abgestuft mit einem umlaufenden erhöhten Außenrand und einem gegen den Außenrand vertieften Innenrand ausgebildet ist, die durch eine Abstufungsfläche miteinander verbunden sind.

Bei dem Substrat handelt es sich vorzugsweise um ein DCB-Substrat (Direct Copper Bonding-Substrate).

Ein derartiges Leistungshalbleitermodul ist in der nachveröffentlichten Offenlegungsschrift DE 10 2006 052 607 A1 der Anmelderin beschrieben. Bei diesem Leistungshalbleitermodul wird ein Produktionsausschuss durch ungewolltes Verdrehen des Substrates in Bezug zum becherförmigen Gehäuse minimiert. Es hat sich jedoch gezeigt, dass trotz der Ausbildung des becherförmigen Gehäuses mit Verdrehsicherungsnoppen ein Kontakt der Ecken des Substrates mit dem Eckenbereich des Becherrandes des Gehäuses infolge der AbmessungsToleranzen des Substrates und/oder des Gehäuses nicht zuverlässig ausschließbar ist, woraus ein Produktionsausschuss des Leistungshalbleitermoduls dadurch resultiert, dass das Substrat mit wenigstens einer seiner Ecken in den Eckenbereich des Becherrandes des Gehäuses hineindrückt. Hervorgerufen wird dieser unerwünschte mögliche Kontakt des Substrates mit einer seiner Ecken mit dem zugehörigen Eckenbereich des Becherrandes des Gehäuses beispielsweise dadurch, dass das Substrat relativ große Abmessungstoleranzen seines Außenrandes aufweist. Diese Abmessungstoleranzen sind bspw. dadurch bedingt, dass das Substrat üblicherweise durch Laserritzen aus einem entsprechend großen Mehrfach-Substrat hergestellt wird, wobei durch das besagte Laserritzen das Mehrfach-Substrat mit entsprechenden Sollbruchlinien ausgebildet wird, entlang welchen das Mehrfach-Substrat in eine Anzahl Substrate auseinander gebrochen wird.

Aus der DE 195 18 753 A1 ist weiterhin bekannt, derartige Substrate in ein Gehäuse zu kleben. Hierbei wird auf dem Außenrand des Substrats ein Klebstoff aufgebracht, der bei Druckbeaufschlagung in eine Fließausnehmung zwischen Gehäuse und Substrat fließt. Dort ist weiterhin an beliebiger Stellte, beispielhaft auch in den Eckenbereichen, der Umfangswand des Gehäuses mindestens eine Klebstoffausnahme vorgesehen, in die weiterer überschüssiger Klebstoff einfließen kann.

In Kenntnis dieser Gegebenheiten liegt der Erfindung die Aufgabe zugrunde, ein Leistungshalbleitermodul der eingangs genannten Art zu schaffen, wobei ein Kontakt von Ecken des Substrates mit den zugehörigen Eckenbereichen des Becherrandes des Gehäuses mit konstruktiv einfachen Mitteln verhindert und ein daraus resultierender Produktionsausschuss vermieden wird.

Diese Aufgabe wird erfindungsgemäß durch die Merkmale des Anspruches 1, d.h. dadurch gelöst, dass die den erhöhten Außenrand mit dem vertieften Innenrand verbindende Abstufungsfläche des Becherrandes des Gehäuses in den Eckenbereichen des Becherrandes des Gehäuses jeweils mit einer eckkonform abgewinkelten Erweiterung ausgebildet ist.

Durch die Ausbildung der Eckenbereiche des Becherrandes des Gehäuses mit den abgewinkelten Erweiterungen ergibt sich der Vorteil, dass die Ecken des Substrates jederzeit, d.h. auch dann von den Eckenbereichen des Becherrandes des Gehäuses beabstandet sind, wenn das Substrat gegen das Gehäuse, d.h. gegen den Becherrand des Gehäuses unbeabsichtigt verdreht ist.

Weist das Substrat eine quadratische oder mindestens annähernd quadratische Grundfläche und der Becherrand des Gehäuses eine entsprechende Grundflächengestalt auf, so ist es bevorzugt, wenn die jeweilige abgewinkelte Erweiterung im Eckenbereich des Becherrandes des Gehäuses zwei gleich lange Erweiterungsschenkel aufweist. Besitzt das Substrat eine rechteckige Grundflächengestalt, so sind die beiden Erweiterungsschenkel der abgewinkelten Erweiterung vorzugsweise an das Längen-zu-Breiten-Verhältnis des Substrates angepasst dimensioniert.

Bevorzugt ist es bei dem erfindungsgemäßen Leistungshalbleitermodul, wenn der Innenrand des becherförmigen Gehäuses mit Erhebungen und der Außenrand mit Verdrehsicherungsnoppen ausgebildet ist, und wenn das Substrat mit seinem an seinen Außenrand innenseitig angrenzenden Randbereich an den Erhebungen anliegt. Durch eine derartige Ausbildung ergibt sich der Vorteil, dass ein ungewollte Verdrehung des Substrates relativ zum Gehäuse, d.h. zum Becherrand desselben durch die Verdrehsicherungsnoppen in jedem Fall definiert begrenzt wird.

Zweckmäßig kann es sein, wenn jeder Erweiterungsschenkel einen zur zugehörigen Abstufungsfläche parallelen Schenkelabschnitt und einen sich daran anschließenden Konusabschnitt aufweist. Die beiden Schenkelabschnitte sind vorzugsweise durch einen Radiusabschnitt miteinander verbunden.

Als vorteilhaft hat es sich erwiesen, wenn der jeweilige Konusabschnitt an eine zugehörige Verdrehsicherungsnoppe angrenzt.

Das erfindungsgemäße Leistungshalbleitermodul weist den Vorteil auf, dass bei einer konstruktiv einfachen Ausbildung auf einfache Weise erreicht wird, dass das Substrat mit den Ecken seines Außenrandes auch bei einer Ausnutzung der maximalen erlaubten Abmessungstoleranzen nicht am Becherrand des Gehäuses schabt. Ein weiterer Vorteil besteht darin, dass die erfindungsgemäße Ausbildung den beispielsweise gemäß der DE 10 2004 021 927 A1 ausgebildeten Beschichtungsprozess des Substrates positiv beeinflusst, weil sich das auf das Substrat aufgebrachte Beschichtungsmaterial im Eckenbereich nicht am Gehäuse anlegen kann.

Weitere Einzelheiten, Merkmale und Vorteile ergeben sich aus der nachfolgenden Beschreibung eines in der Zeichnung dargestellten Ausführungsbeispieles eines erfindungsgemäßen Leistungshalbleitermoduls bzw. wesentlicher Einzelheiten desselben.

Es zeigen:
- Figur 1: eine Ansicht des Halbleitermoduls in Blickrichtung von unten,
- Figur 2: schematisch abschnittweise stark vergrößert und nicht maßstabgetreu einen Schnitt entlang der Schnittlinie II-II in Figur 1,
- Figur 3: einen Abschnitt einer Ansicht des Becherrandes des Gehäuses in einem vergrößerten Maßstab und nicht maßstabgetreut in Blickrichtung von unten,
- Figur 4: abschnittweise perspektivisch eine Ausbildung des becherförmigen Gehäuses,
- Figur 5: in einem größeren Maßstab das Detail V in Figur 1, und
- Figur 6: in einem der Figur 5 entsprechenden Maßstab das Detail VI in Figur 1.

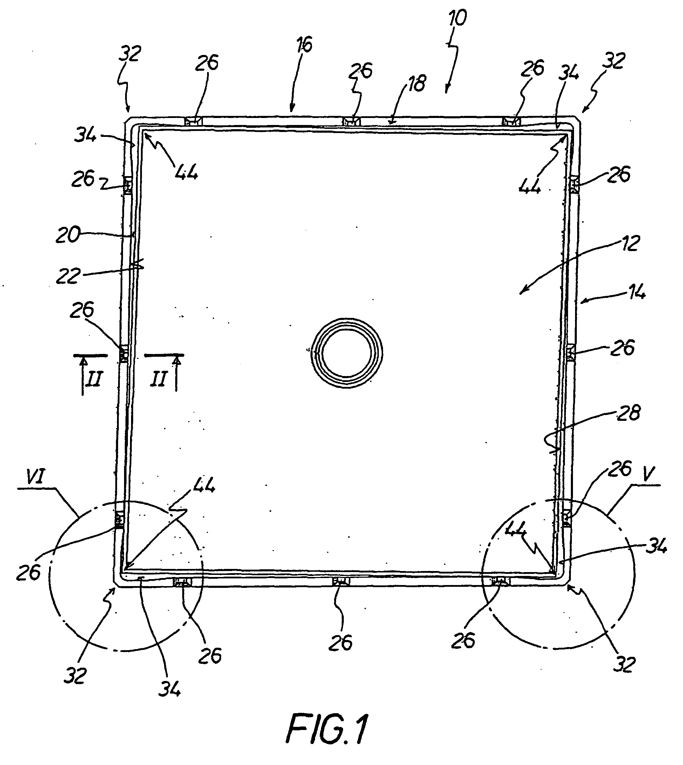

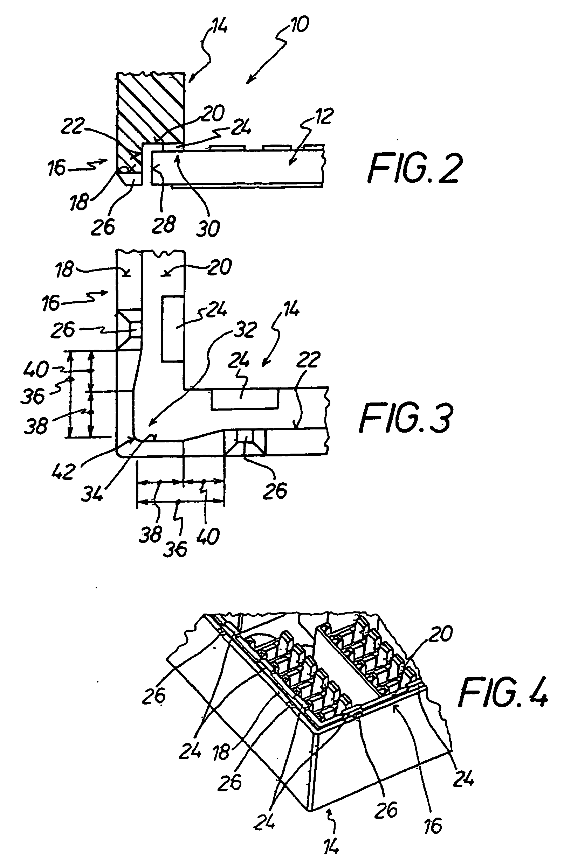

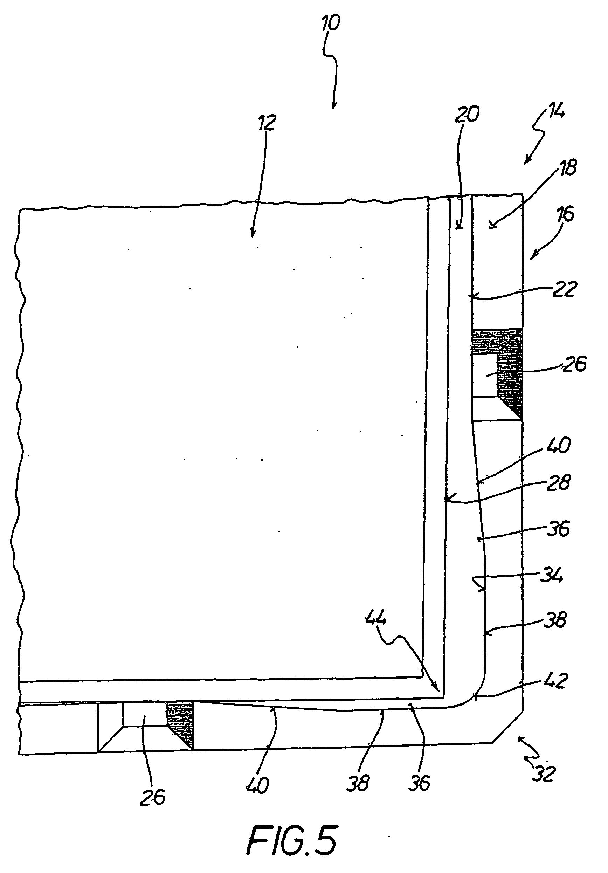

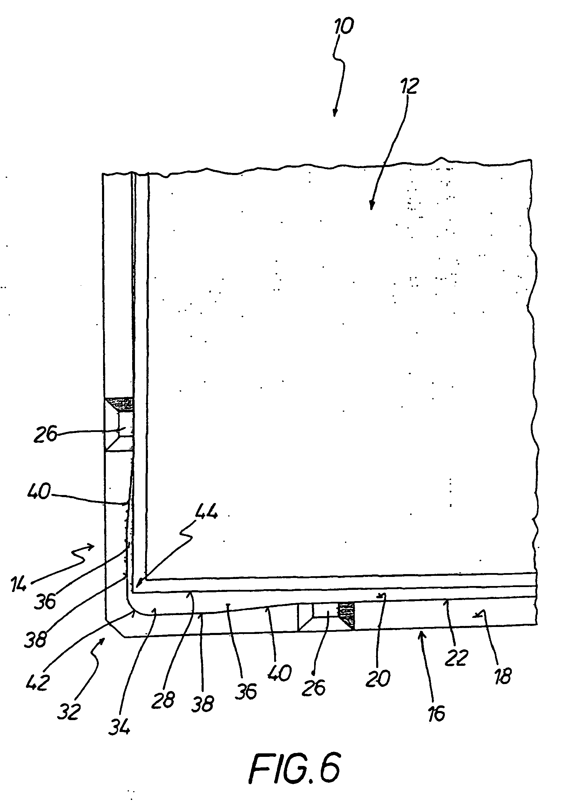

Figur 1 zeigt in einer Ansicht von unten eine Ausbildung des Leistungshalbleitermoduls 10 mit einem Substrat 12 und einem becherförmigen Gehäuse 14. Wie auch aus den Figuren 2 bis 6 ersichtlich ist, weist das becherförmige Gehäuse 14 einen umlaufenden Becherrand 16 auf, der abgestuft mit einem umlaufenden erhöhten Außenrand 18 und einem gegen diesen vertieften Innenrand 20 ausgebildet ist. Der erhöhte Außenrand 18 und der vertiefte Innenrand 20 sind miteinander durch eine Abstufungsfläche 22 verbunden.

Der vertiefte Innenrand 20 ist mit voneinander beabstandeten Erhebungen 24 und der erhöhte Außenrand 18 ist mit voneinander beabstandeten Verdrehsicherungsnoppen 26 ausgebildet. Das Substrat 12 liegt mit seinem an seinen Außenrand 28 angrenzenden Randbereich 30 seiner Oberseite an den Erhebungen 24 des Gehäuses 14 an. Bei dem Substrat 12 handelt es sich vorzugsweise um ein DCB-Substrat (= Direct Copper Bonding-Substrate).

Die Abstufungsfläche 22 zwischen dem erhöhten Außenrand 18 und dem vertieften Innenrand 20 des becherförmigen Gehäuses 14 ist in den Eckenbereichen 32 des umlaufenden Becherrandes 16 des becherförmigen Gehäuses 14 jeweils mit einer eckkonform abgewinkelten Erweiterung 34 ausgebildet. Die jeweilige abgewinkelte Erweiterung 34 weist zwei zueinander senkrecht orientierte Erweiterungsschenkel 36 auf, die in Figur 3 durch die Doppelpfeile 36 verdeutlicht sind. Der jeweilige Erweiterungsschenkel 36 weist einen zur zugehörigen Abstufungsfläche 22 parallelen Schenkelabschnitt, der in Figur 3 durch die Doppelpfeile 38 verdeutlich ist, und einen sich daran anschließenden Konusabschnitt auf, der in Figur 3 durch die Doppelpfeile 40 angedeutet ist. Die beiden zueinander senkrecht orientierten Schenkelabschnitte 38 sind miteinander durch einen Radiusabschnitt 42 verbunden. Der jeweilige Konusabschnitt 40 grenzt an eine zugehörige Verdrehsicherungsnoppe 26 an.

In Figur 1 ist ein Leistungshalbleitermodul 10 dargestellt, bei welchem das Substrat 12 in Bezug zum becherförmigen Gehäuse 14 bzw. zu dessen umlaufendem Becherrand 16 infolge der Abmessungstoleranzen des Außenrandes 28 des Substrats 12 und des umlaufenden Becherrandes 16 und somit den von dessen erhöhtem Außenrand 18 materialeinstückig wegstehenden Verdrehsicherungsnoppen 26 im Uhrzeigersinn geringfügig verdreht ist, so dass der Außenrand 28 des Substrats 12 nur jeweils an einer Verdrehsicherungsnoppe 26 anliegt, wobei durch die Ausbildung der Abstufungsfläche 22 in den Eckenbereichen 32 des Becherrandes 16 jeweils mit einer eckkonform abgewinkelten Erweiterung 34 verhindert wird, dass das Substrat 12 mit seinen Ecken 44 mit den Eckenbereichen 34 des umlaufenden Becherrandes 16 des Gehäuses 14 in Kontakt kommt und eine daraus resultierende Beschädigung und somit ein Produktsausfall vermieden wird.

Gleiche Einzelheiten sind in den Figuren 1 bis 6 jeweils mit denselben Bezugsziffern bezeichnet, so dass es sich erübrigt, in Verbindung mit den Zeichnungsfiguren alle Einzelheiten jeweils detailliert zu beschreiben.

### Bezugsziffernliste:

- 10: Leistungshalbleitermodul
- 12: Substrat (von 10)
- 14: becherförmiges Gehäuses (von 10)
- 16: umlaufender Becherrand (von 14)
- 18: erhöhter Außenrand (von 16)
- 20: vertiefter Innenrand (von 16)
- 22: Abstufungsfläche (zwischen 18 und 20)
- 24: Erhebungen (an 20 für 12)
- 26: Verdrehsicherungsnoppen (an 18 für 28)
- 38: Außenrand (von 12)
- 30: Randbereich (von 12)
- 32: Eckenbereiche (von 16)
- 34: abgewinkelte Erweiterung (von 22 bei 32)
- 36: Erweiterungsschenkel (von 34)
- 38: paralleler Schenkelabschnitt (von 36)
- 40: Konusabschnitt (von 36)
- 42: Radiusabschnitt (zwischen 38 und 38)
- 44: Ecken (von 12)

## Patentansprüche

1. Leistungshalbleitermodul (10) mit einem Substrat (12), dessen Oberseite mit mindestens einem Leistungshalbleiterbauelement bestücht ist, und einem becherförmigen Gehäuse (14), wobei der Becherrand (16) des Gehäuses (14) abgestuft mit einem umlaufenden erhöhten Außenrand (18) und einem gegen den Außenrand (18) vertieften Innenrand (20) ausgebildet ist, die durch eine Abstufungsfläche (22) miteinander verbunden sind, wobei das Substrat (12) mit seinem an seinen Außenrand (28) angrenzenden Randbereich (30) seiner Oberseite an das Gehäuse (14) anliegt und wobei den Ecken des Substrates (12) zugehörige Eckenbereiche (32) des Becherrandes (16) des Gehäuses (14) zugeordnet sind, und wobei
die Abstufungsfläche (22) in den Eckenbereichen (32) des Becherrandes (16) des Gehäuses (14) jeweils mit einer eckkonform abgewinkelten Erweiterung (34) ausgebildet ist, **dadurch gekennzeichnet,**
**dass** der Innenrand (20) des becherförmigen Gehäuses (14) mit Erhebungen (24) und der Außenrand (18) mit Verdrehsicherungsnoppen (26) ausgebildet ist, und dass das Substrat (12) mit seinem an seinen Außenrand (28) angrenzenden Randbereichen (30) seiner Oberseite an den Erhebungen (24) anliegt.

2. Leistungshalbleitermodul (10) nach Anspruch 1,
**dadurch gekennzeichnet,**
**dass** die jeweilige abgewinkelte Erweiterung (34) zwei zueinander senkrecht orientierte Erweiterungsschenkel (36) aufweist.

3. Leistungshalbleitermodul (10) nach Anspruch 2,
**dadurch gekennzeichnet,**
**dass** jeder Erweiterungsschenkel (36) einen zur zugehörigen Abstufungsfläche (22) parallelen Schenkelabschnitt (38) und einen sich daran anschließende Konusabschnitt (40) aufweist.

4. Leistungshalbleitermodul (10) nach Anspruch 3,
**dadurch gekennzeichnet,**
**dass** die beiden Schenkelabschnitte (38) durch einen Radiusabschnitt (42) miteinander verbunden sind.

5. Leistungshalbleitermodul (10) nach Anspruch 3,
**dadurch gekennzeichnet,**
**dass** der jeweilige Konusabschnitt (40) an eine zugehörige Verdrehsicherungsnoppe (26) angrenzt.

## Claims

1. A power semiconductor module (10) with a substrate (12), whose upper face is populated with at least one power semiconductor component, and a tray-shaped housing (14), wherein the tray edge (16) of the housing (14) is designed to be stepped with a peripheral raised outer edge (18) and an inner edge (20) lowered with respect to the outer edge (18), which edges are connected with one another by means of a stepped surface (22), wherein
the substrate (12) with its edge region (30) of its upper face adjacent to its outer edge (28) sits against the housing (14), and wherein
related corner regions (32) of the tray edge(16) of the housing (14) are assigned to the corners of the substrate (12), and wherein
the stepped surface (22) in each of the corner regions (32) of the tray edge (16) of the housing (14) is designed with an angled enlargement (34) conformal with the corner,
**characterised in that** the inner edge (20) of the tray-shaped housing (14) is designed with raised areas (24) and the outer edge (18) is designed with anti-rotation pimples (26), and **in that** the edge regions (30) of the upper face of the substrate (12), adjacent to its outer edge (28), sit on the raised areas (24).

2. The power semiconductor module (10) in accordance with Claim 1,
**characterised in that** the respective angled enlargement (34) has two enlargement arms (36) oriented at right-angles to one another.

3. The power semiconductor module (10) in accordance with Claim 2,
**characterised in that** each enlargement arm (36) has an arm section (38) parallel to the related stepped surface (22) and a conical section (40) adjoining the latter.

4. The power semiconductor module (10) in accordance with Claim 3,
**characterised in that** the two arm sections (38) are connected with one another by means of a radius section (42).

5. The power semiconductor module (10) in accordance with Claim 3,
**characterised in that** the respective conical section (40) is adjacent to a related anti-rotation pimple (26).

## Revendications

1. Module à semi-conducteurs de puissance (10) doté d'un substrat (12), dont la face supérieure est équipée avec au moins un composant à semi-conducteurs de puissance, et d'un boîtier (14) en forme de gobelet, le bord de gobelet (16) du boîtier (14) étant conçu de façon étagée avec un bord extérieur (18) surélevé périphérique et un bord intérieur (20) en creux vers le bord extérieur (18), lesquels sont reliés l'un à l'autre par une surface de dégradé (22), le substrat (12) s'appliquant par sa zone périphérique (30), contiguë à son bord extérieur (28), de sa face supérieure sur le boîtier (14) et des zones d'angle (32) spécifiques du bord de gobelet (16) du boîtier (14) étant attribuées aux angles du substrat (12), et
la surface de dégradé (22) étant conçue dans chacune des zones d'angle (32) du bord de gobelet (16) du boîtier (14) avec une extension (34) coudée en fonction de l'angle, **caractérisé en ce que**
le bord intérieur (20) du boîtier (14) en forme de gobelet est conçu avec des élévations (24) et le bord extérieur (18) avec des ergots de blocage de rotation (26), et **en ce que** le substrat (12) s'applique par ses zones périphériques (30), contiguës à son bord extérieur (28), de sa face supérieure sur les élévations (24).

2. Module à semi-conducteurs de puissance (10) selon la revendication 1,
**caractérisé en ce que**
l'extension (34) coudée respective présente deux branches d'extension (36) orientées perpendiculairement l'une à l'autre.

3. Module à semi-conducteurs de puissance (10) selon la revendication 2,
**caractérisé en ce que**
chaque branche d'extension (36) présente une partie de branche (38) parallèle à la surface de dégradé (22) spécifique et une partie de cône (40) se raccordant à la première.

4. Module à semi-conducteurs de puissance (10) selon la revendication 3,
**caractérisé en ce que**
les deux parties de branche (38) sont reliées l'une à l'autre par une partie de rayon (42).

5. Module à semi-conducteurs de puissance (10) selon la revendication 3,
**caractérisé en ce que**
la partie de cône (40) respective est contiguë à un ergot de blocage de rotation (26) spécifique.
